# DEMANDE DE BREVET EUROPEEN

(11) **EP 4 235 749 A1**
(43) Date de publication de la demande: **30.08.2023**
(21) Numéro de dépôt: 23156458.4
(22) Date de dépôt: 14.02.2023
(51) Int. Cl.: H01L 21/18, H01L 21/04

(54) **PROCÉDÉ DE COLLAGE PAR ACTIVATION DE SURFACE PAR BOMBARDEMENT D'IONS OU D'ATOMES D'UNE PREMIÈRE SURFACE D'UN PREMIER SUBSTRAT À UNE DEUXIÈME SURFACE D'UN DEUXIÈME SUBSTRAT**

(30) Priorité: 28.02.2022 FR 2201744
(71) Demandeur: COMMISSARIAT À L'ÉNERGIE ATOMIQUE ET AUX ÉNERGIES ALTERNATIVES, 75015 Paris (FR)
(72) Inventeur: FOURNEL, Frank, 38054 GRENOBLE CEDEX 09 (FR); ABADIE, Karine, 38054 GRENOBLE CEDEX 09 (FR); LOMONACO, Quentin, 38054 GRENOBLE CEDEX 09 (FR)
(74) Mandataire: Cabinet Camus Lebkiri

(57) **Abrégé**

Un aspect de l'invention concerne un procédé (100) de collage par activation de surface par bombardement d'ions ou d'atomes d'une première surface d'un premier substrat à une deuxième surface d'un deuxième substrat, le matériau du premier substrat au niveau de la première surface comprenant au moins deux espèces chimiques dont l'une, dite espèce d'intérêt, s'appauvrit lors de l'activation par bombardement d'ions ou d'atomes, le procédé (100) comprenant :
- une étape(1 E3) de dépôt sur la première surface du premier substrat d'une couche de l'espèce d'intérêt ;
- une étape (1 E5) d'activation de la première surface par un bombardement de la première surface par un faisceau d'ions ou d'atomes de sorte à consommer l'intégralité de la couche d'espèce déposée précédemment ;
- une étape (1 E5') d'activation de la deuxième surface par un bombardement de la deuxième surface par un faisceau d'ions ou d'atomes ;
- une étape (1 E6) de mise en contact de la première surface du premier substrat avec la deuxième surface du deuxième substrat....

## Description

### DOMAINE TECHNIQUE DE L'INVENTION

Le domaine technique de l'invention est celui du collage direct.

La présente invention concerne un procédé de collage par activation de surface et en particulier un procédé de collage comprenant une étape de dépôt d'une couche de l'espèce d'intérêt au niveau d'au moins une des surfaces à coller.

### ARRIERE-PLAN TECHNOLOGIQUE DE L'INVENTION

Le collage direct est une technique bien connue et utilisée pour des applications industrielles comme la fabrication de substrats SOI ou bien encore d'imageurs par exemple. Le collage direct consiste en un collage spontané entre deux surfaces sans apport de matière, et notamment sans couche épaisse de liquide. Il est néanmoins possible d'avoir quelques monocouches d'eau adsorbées sur les surfaces mais ces dernières sont macroscopiquement sèches. Une des caractéristiques principales du collage direct est son énergie d'adhérence ou autrement appelée son énergie de collage. C'est l'énergie qu'il faut utiliser pour séparer les deux surfaces collées. Le type le plus courant de collage direct est le collage à température et pression ambiante de deux surfaces hydrophiles. Pour obtenir une énergie d'adhérence satisfaisante, il faut en général recuire ces collages au-delà de 200°C.

D'autres techniques de collages ont également été développées, comme les collages SAB (pour Surface Activation Bounding en anglais ou collage par activation de surface) et ADB (pour Atomic Diffusion Bounding en anglais ou collage par diffusion atomique) qui se réalisent sous ultra vide. Le lecteur pourra notamment se reporter aux documents H. Takagi, R. Maeda, T.R. Chung, and T. Suga, Sensors and Actuators A: Physical 70, 164 (1998) et M. Uomoto, A. Muraoka, and T. Shimatsu, ECS Trans. 86, 199 (2018). Ces collages ont la particularité de présenter une énergie d'adhérence très importante dès la température ambiante. Très souvent une pression uniaxiale est appliquée pendant les collages ADB et SAB, mais toujours à température ambiante. Il ne s'agit donc pas à proprement parler de thermocompression mais de pression seulement pendant le collage direct.

Plus particulièrement, dans le collage SAB, la surface à coller est bombardée par un faisceau d'ions ou d'atomes (très souvent de l'argon) de sorte à retirer les oxydes de surfaces pour ne laisser que des liaisons pendantes non appariées (activant ainsi la surface). En mettant deux surfaces ainsi traitées en contact, on obtient directement des liaisons covalentes à l'interface de collage. Cependant ce type de collages souffre de certains désavantages. Notamment, si les matériaux que l'on cherche à coller ne sont pas des matériaux composés d'une seule espèce chimique, le bombardement n'a pas la même efficacité sur les différents types d'atomes qui compose les matériaux ce qui peut induire une rugosification préjudiciable au collage. Surtout, cette différence d'efficacité peut induire un changement de composition de la surface avec un appauvrissement d'un ou de plusieurs des espèces constituants le matériau. Par exemple, le SiC s'appauvrit en silicium et une couche riche en carbone se retrouve à l'interface après bombardement. Or, cette couche présente une moindre résistance mécanique que le SiC nominal comme le décrit le document T. Suga and F. Mu, in 2018 7th Electronic System-Intégration Technology Conférence (2018), pp. 1-4. Il est possible de contourner le problème avec l'utilisation d'un SAB « modifié », où un dépôt d'un autre matériau est réalisé pendant ou avant le bombardement d'argon afin de coller avec cette nouvelle espèce chimique. C'est ainsi qu'il est possible de coller par SAB de l'oxyde de silicium ou des polymères par exemple. Le SAB modifié est intéressant mais cela demande une machine particulière et l'espèce rajoutée se retrouve à l'interface de collage.

Il existe donc un besoin d'un procédé de collage permettant de limiter l'appauvrissement d'un des constituants des surfaces que l'on souhaite coller sans toutefois nécessiter l'ajout d'une couche tierce à l'interface de collage.

### RESUME DE L'INVENTION

L'invention offre une solution aux problèmes évoqués précédemment, en permettant, à l'aide d'une couche d'une espèce d'intérêt avant l'étape d'activation, de limiter l'appauvrissement du matériau. De plus, cette couche étant entièrement consommée lors de l'activation, le collage peut être réalisé sans la présence d'une couche tierce à l'interface de collage.

L'invention concerne un procédé de collage par activation de surface par bombardement d'ions ou d'atomes d'une première surface d'un premier substrat à une deuxième surface d'un deuxième substrat, le matériau du premier substrat au niveau de la première surface comprenant au moins deux espèces chimiques dont l'une, dite espèce d'intérêt, s'appauvrit lors de l'activation par bombardement d'ions ou d'atomes, le procédé comprenant :
- Une étape de dépôt sur la première surface du premier substrat d'une couche de l'espèce d'intérêt ;
- Une étape d'activation de la première surface par un bombardement de la première surface par un faisceau d'ions ou d'atomes de sorte à consommer l'intégralité de la couche d'espèce déposée précédemment ;
- Une étape d'activation de la deuxième surface par un bombardement de la deuxième surface par un faisceau d'ions ou d'atomes ;
- Une étape de mise en contact de la première surface du premier substrat avec la deuxième surface du deuxième substrat.

Outre les caractéristiques qui viennent d'être évoquées dans le paragraphe précédent, le procédé selon un aspect de l'invention peut présenter une ou plusieurs caractéristiques complémentaires parmi les suivantes, considérées individuellement ou selon toutes les combinaisons techniquement possibles.

Dans un mode de réalisation, le procédé comprend, avant l'étape de dépôt, une étape de préparation de la première surface et/ou de la deuxième surface comportant le nettoyage de ladite ou desdites surfaces.

Dans un mode de réalisation, le procédé comprend, avant l'étape de dépôt et après l'étape de préparation si une telle étape est mise en oeuvre, une étape d'activation préliminaire de la première surface du premier substrat et/ou de la deuxième surface du deuxième substrat.

Dans un mode de réalisation, l'espèce d'intérêt du matériau au niveau de la première surface du premier substrat est dite première espèce d'intérêt et le matériau au niveau de la deuxième surface du deuxième substrat comprend au moins deux espèces chimiques dont l'une, dite deuxième espèce d'intérêt, s'appauvrit lors de l'activation par bombardement d'ions ou d'atomes, le procédé comprenant avant, pendant ou après l'étape de dépôt de la couche de la première espèce d'intérêt sur la première surface du premier substrat, une étape de dépôt d'une couche de la deuxième espèce d'intérêt sur la deuxième surface du deuxième substrat, l'étape d'activation de la deuxième surface étant effectué de sorte à consommer l'intégralité de la couche de la deuxième espèce d'intérêt déposée précédemment.

Dans un mode de réalisation, le procédé comprend, après l'étape ou les étapes de dépôt, une étape de recuit de la couche ou des couches déposées précédemment.

Dans un mode de réalisation, l'étape d'activation est prolongée après la consommation de la couche de l'espèce d'intérêt et, lorsqu'une telle couche existe, de la couche de la deuxième espèce d'intérêt, de sorte à obtenir une gravure partielle de la première surface du premier substrat et, lorsque la couche de la deuxième espèce d'intérêt a été déposée, une gravure partielle de la deuxième surface du deuxième substrat.

Dans un mode de réalisation, le matériau au niveau de la première surface du premier substrat et/ou le matériau au niveau de la deuxième surface du deuxième substrat est choisi parmi le SiGe, le SiC, le CGe.

Dans un mode de réalisation l'étape d'activation préliminaire, l'étape ou les étapes de dépôt, les étapes d'activation et l'étape de mise en contact sont réalisées dans une machine de collage par activation de surface comprenant une chambre de dépôt permettant le dépôt de la ou des couches de l'espèce d'intérêt.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.

La [Fig. 1] montre un ordinogramme d'un procédé selon l'invention dans lequel les étapes optionnelles apparaissent en pointillé.

La [Fig. 2] illustre une étape de dépôt de la couche de l'espèce d'intérêt du procédé selon l'invention.

La [Fig. 3] illustre une étape d'activation du procédé selon l'invention.

### DESCRIPTION DETAILLEE

Les figures sont présentées à titre indicatif et nullement limitatif de l'invention.

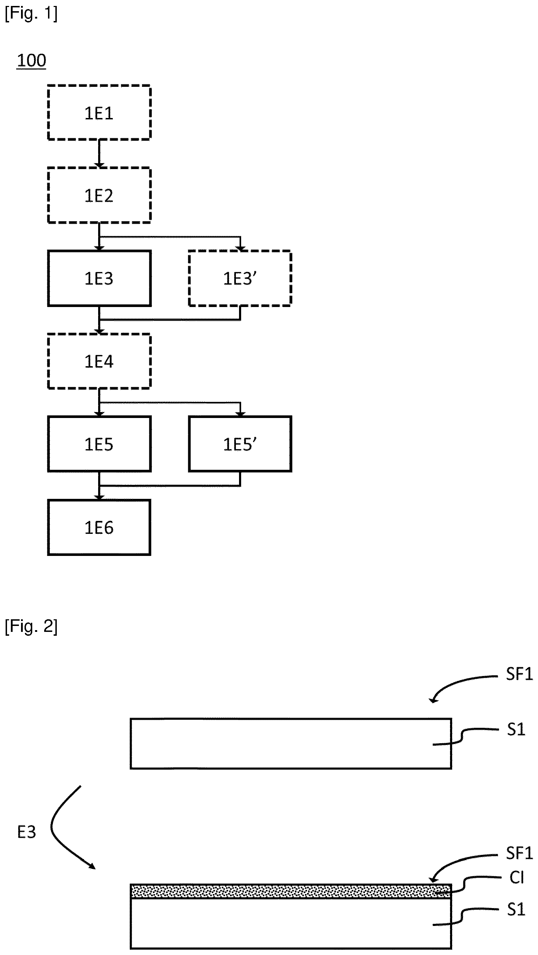

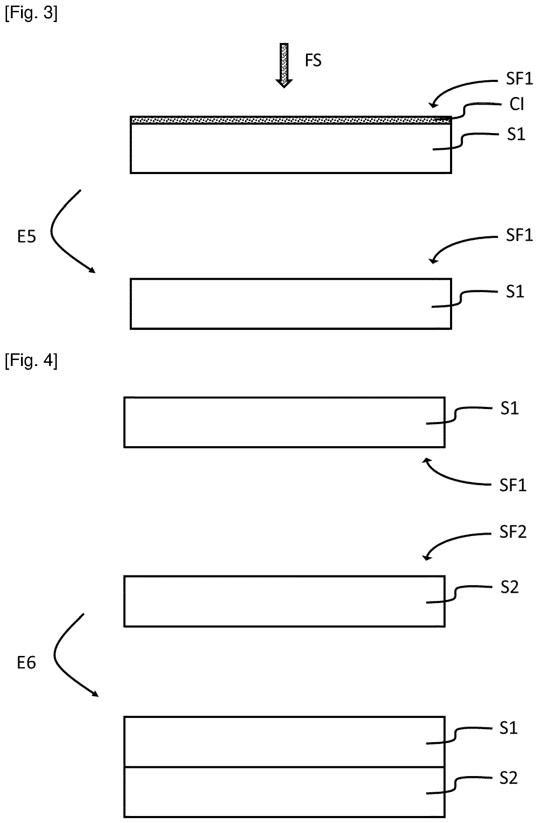

Un premier aspect de l'invention illustré aux [Fig. 1] à [Fig. 4] concerne un procédé 100 de collage par activation de surface par bombardement d'ions ou d'atomes d'une première surface SF1 d'un premier substrat S1 à une deuxième surface SF2 d'un deuxième substrat S2, le matériau du premier substrat S1 au niveau de la première surface SF1 comprenant au moins deux espèces chimiques (par exemple un matériau binaire) dont l'une, dite espèce d'intérêt, s'appauvrit lors de l'activation par bombardement d'ions ou d'atomes.

Dans un mode de réalisation, l'espèce d'intérêt du matériau au niveau de la première surface SF1 est dite première espèce d'intérêt et le matériau du deuxième substrat S2 au niveau de la deuxième surface SF2 comprend au moins deux espèces chimiques dont l'une, dite deuxième espèce d'intérêt, s'appauvrit lors de l'activation par bombardement d'ions ou d'atomes.

Dans un mode de réalisation, le matériau au niveau de la première surface SF1 du premier substrat S1 et/ou le matériau au niveau de la deuxième surface SF2 du deuxième substrat S2 est choisi parmi le SiGe, le SiC, le CGe ou tout autre matériau comprenant deux espèces chimiques dont l'espèce d'intérêt peut être déposée. Dans un exemple de réalisation, le premier substrat S1 et le deuxième substrat S2 sont des substrats de SiC, ayant par exemple un diamètre de 150 mm et une épaisseur de 325 µm.

### Etape 1E1 de préparation de la première surface et/ou de la deuxième surface (optionnelle)

Dans un mode de réalisation, le procédé 100 comprend une étape 1E1 de préparation de la première surface SF1 du premier substrat S1 et/ou de la deuxième surface SF2 du deuxième substrat S2 comprenant par exemple le nettoyage des surfaces en question. Dans un exemple de réalisation, lors de cette étape 1E1 de préparation, la première et la deuxième surfaces SF1, SF2 sont nettoyées par Caro (un mélange d'acide sulfurique 96% et d'eau oxygénée 30% (3 :1)) à 140°C et par SC1 (un mélange d'ammoniaque 30%, d'eau oxygénée 30% et d'eau désionisée (1 :1 :5)) à 70°C.

### Etape 1E2 d'activation préliminaire (optionnelle)

Dans un mode de réalisation, le procédé 100 comprend une étape 1E2 d'activation préliminaire de la première surface SF1 et, éventuellement, de la deuxième surface SF2, de préférence à l'aide d'un faisceau d'atomes ou d'ions. C'est notamment le cas lorsque l'étape 1E3 de dépôt à suivre est effectuée dans une machine SAB, auquel cas l'activation préliminaire est réalisée à l'aide d'un faisceau d'atomes ou d'ions. Dans un exemple de réalisation, la première surface et la deuxième surface sont soumises à une activation de surface de type SAB sous ultra vide (pression inférieure ou égale à 10⁻⁸ mbar) avec un faisceau d'atomes ou d'ions d'Argon de 200eV et 150mA, le temps de l'activation étant de 1mn.

### Etape 1E3, 1E3' de dépôt d'une couche de l'espèce d'intérêt

Comme illustré à la [Fig. 2], le procédé 100 selon l'invention comprend une étape 1E3 de dépôt sur la première surface SF1 d'une couche CI de l'espèce d'intérêt. Dans un mode de réalisation, lorsque le matériau du deuxième substrat S2 au niveau de la deuxième surface SF2 comprend au moins deux espèces chimiques dont l'une, dite deuxième espèce d'intérêt, s'appauvrit lors de l'activation par bombardement d'ions ou d'atomes, le procédé 100 comprend également une étape 1E3' de dépôt sur la deuxième surface SF2 d'une couche de la deuxième espèce d'intérêt. Lorsque la première espèce d'intérêt et la deuxième espèce d'intérêt sont identiques, par exemple parce que le matériau au niveau de la première surface SF1 est identique au matériau au niveau de la deuxième surface SF2, ces deux étapes 1E3, 1E3' de dépôt peuvent être réalisées de manière simultanée.

Dans un exemple de réalisation, le premier substrat S1 et le deuxième substrat S2 sont en SiC et, lors de cette étape, une couche de 10 nm de silicium amorphe est déposée sur la première surface SF1 du premier substrat S1 et la deuxième surface SF2 du deuxième substrat S2. Dans cet exemple, l'étape 1E3 de dépôt est ensuite suivie d'une étape 1E4 de recuit.

Dans un exemple de réalisation alternatif, le premier substrat et le deuxième substrats sont disposés dans une machine SAB (pour Surface Activated Bonding en anglais ou Collage par Activation de Surface) qui dispose d'une chambre de dépôt permettant le dépôt d'une couche de l'espèce d'intérêt et, lors de cette étape, éventuellement précédée de l'étape 1E2 d'activation préliminaire telle que décrite précédemment, une couche CI et Cl2 de silicium amorphe de 10nm d'épaisseur est déposée respectivement sur la première surface SF1 du premier substrat S1 et la deuxième surface SF2 du deuxième substrat S2, ledit dépôt 1E3, 1E3' étant réalisé sous ultra vide par une technique dite « sputtering » en mode RF avec une puissance de 250W et sous un flux de 50 sscm (pour Standard Cubic Centimeters per Minute ou centimètre cube par minute dans les conditions standard de température et de pression) d'Argon.

### Etape 1E4 de recuit (optionnelle)

Dans un mode de réalisation, le procédé 100 comprend également, à l'issue de l'étape 1E3, 1E3' de dépôt, une étape 1E4 de recuit. Dans un exemple de réalisation, la température lors de l'étape 1E4 de recuit est comprise entre 600°C et 800 °C, par exemple 700°C, cette température étant maintenue pendant un temps compris entre 5 minutes et 15 minutes, par exemple une durée égale à 10 minutes.

### Etapes 1E5,1E5' d'activation de la première surface et de la deuxième surface

Le procédé 100 comprend ensuite une étape 1E5 d'activation de la première surface SF1 par le bombardement de la première surface SF1 par un faisceau FS d'ions ou d'atomes de sorte à consommer l'intégralité de la couche Cl1d'espèce déposée précédemment. Il comprend également une étape 1 E5' d'activation de la deuxième surface SF2 par le bombardement de la deuxième surface par un faisceau d'ions ou d'atomes. De préférence, ces deux étapes 1E5, 1E5' sont mises en oeuvre simultanément.

Dans un mode de réalisation, lorsqu'une couche Cl2 de la deuxième espèce d'intérêt a été déposée au niveau de la deuxième surface SF2 du deuxième substrat S2, l'étape 1E5' d'activation de la deuxième surface SF2 est mise en oeuvre de sorte à consommer l'intégralité de la couche Cl2 de la deuxième espèce d'intérêt déposée précédemment.

Dans un exemple de réalisation, lorsque les étapes précédentes n'ont pas été réalisée dans une machine SAB, les étapes 1 E5,1 E5' d'activation sont précédées d'une mise sous ultra vide du premier substrat S1 et du deuxième substrat S2. Puis, les étapes d'activation sont mises en oeuvre simultanément ou séquentiellement à l'aide d'un faisceau d'atomes ou d'ions d'argon de 200eV et 150mA, un tel faisceau étant associé à une vitesse de gravure de 4nm/mn, la durée de ces étapes étant choisie de sorte à retirer la couche de l'espèce d'intérêt déposées précédemment. Par exemple, pour une couche de 10 nm, l'activation est mise en oeuvre pendant 2 minutes et 30s.

Dans un mode de réalisation, l'activation est prolongée après la consommation de la couche CI de l'espèce d'intérêt et, lorsqu'une telle couche existe, de la couche de la deuxième espèce d'intérêt, de sorte à obtenir une gravure partielle de la première surface SF1 du premier substrat S1 et, lorsque la couche de la deuxième espèce d'intérêt a été déposée une gravure partielle de la deuxième surface SF2 du deuxième substrat S2. Cette gravure partielle permet notamment de supprimer la couche d'oxyde susceptible de se former avant le dépôt de la couche de la première espèce d'intérêt ou de la deuxième espèce d'intérêt.

### Etape 1E6 de mise en contact

Le procédé 100 comprend ensuite, une étape 1E6 de mise en contact de la première surface SF1 du premier substrat S1 avec la deuxième surface SF2 du deuxième substrat S2 de sorte à effectuer le collage du premier substrat S1 au deuxième substrat S2.

Dans un mode de réalisation, l'étape 1E2 d'activation préliminaire, l'étape 1E3 ou les étapes 1 E3, 1 E3' de dépôt, les étapes 1E5, 1 E5' d'activation et l'étape 1 E6 de mise en contact sont réalisées dans une machine de collage par activation de surface (SAB) comprenant une chambre de dépôt permettant le dépôt de la ou des couches de l'espèce d'intérêt. Ainsi, ces différentes étapes peuvent être réalisée sous un même vide, ici un ultra vide, c'est-à-dire sans venir rompre le vide entre ces différentes étapes. Cela permet d'obtenir des surfaces et donc un collage de meilleures qualités.

## Revendications

1. Procédé (100) de collage par activation de surface par bombardement d'ions ou d'atomes d'une première surface (SF1) d'un premier substrat (S1) à une deuxième surface (SF2) d'un deuxième substrat (S2), le matériau du premier substrat (S1) au niveau de la première surface (SF1) comprenant au moins deux espèces chimiques dont l'une, dite espèce d'intérêt, s'appauvrit lors de l'activation par bombardement d'ions ou d'atomes, le procédé (100) comprenant :
- Une étape(1E3) de dépôt sur la première surface (SF1) du premier substrat (S1) d'une couche (CI) de l'espèce d'intérêt ;
- Une étape (1E5) d'activation de la première surface (SF1) par un bombardement de la première surface (SF1) par un faisceau (FS) d'ions ou d'atomes de sorte à consommer l'intégralité de la couche d'espèce déposée précédemment ;
- Une étape (1E5') d'activation de la deuxième surface (SF2) par un bombardement de la deuxième surface par un faisceau d'ions ou d'atomes ;
- Une étape (1E6) de mise en contact de la première surface du premier substrat avec la deuxième surface du deuxième substrat.

2. Procédé (100) selon la revendication précédente comprenant, avant l'étape (1E3) de dépôt, une étape (1E1) de préparation de la première surface (SF1) et/ou de la deuxième surface (SF2) comportant le nettoyage de ladite ou desdites surfaces (SF1, SF2).

3. Procédé (100) selon la revendication 1 ou la revendication 2 comprenant, avant l'étape de dépôt (1E3) et après l'étape (1E1) de préparation si une telle étape (1E1) est mise en oeuvre, une étape (1E2) d'activation préliminaire de la première surface (SF1) du premier substrat (S1) et/ou de la deuxième surface (SF2) du deuxième substrat (S2).

4. Procédé (100) selon la revendication précédente dans lequel l'espèce d'intérêt du matériau au niveau de la première surface (SF1) du premier substrat (S1) est dite première espèce d'intérêt et dans lequel le matériau au niveau de la deuxième surface (SF2) du deuxième substrat (S2) comprend au moins deux espèces chimiques dont l'une, dite deuxième espèce d'intérêt, s'appauvrit lors de l'activation par bombardement d'ions ou d'atomes, le procédé (100) comprenant avant, pendant ou après l'étape (1E3) de dépôt de la couche (Cl) de la première espèce d'intérêt sur la première surface (SF1) du premier substrat (S1), une étape (1E3') de dépôt d'une couche de la deuxième espèce d'intérêt sur la deuxième surface (SF2) du deuxième substrat (S2), l'étape d'activation de la deuxième surface étant effectué de sorte à consommer l'intégralité de la couche de la deuxième espèce d'intérêt déposée précédemment.

5. Procédé selon l'une des revendications précédentes comprenant, après l'étape (1 E3) ou les étapes (1 E3,1 E3') de dépôt, une étape (1 E4) de recuit de la couche (CI) ou des couches (CI) déposées précédemment.

6. Procédé (100) selon l'une des revendications précédentes dans lequel l'étape (1 E5) d'activation est prolongée après la consommation de la couche de l'espèce d'intérêt (CI) et, lorsqu'une telle couche existe, de la couche (Cl2) de la deuxième espèce d'intérêt, de sorte à obtenir une gravure partielle de la première surface (SF1) du premier substrat (S1) et, lorsque la couche de la deuxième espèce d'intérêt a été déposée, une gravure partielle de la deuxième surface (SF2) du deuxième substrat (S2).

7. Procédé selon l'une des revendications précédentes dans lequel le matériau au niveau de la première surface (SF1) du premier substrat (S1) et/ou le matériau au niveau de la deuxième surface (SF2) du deuxième substrat (S2) est choisi parmi le SiGe, le SiC, le CGe.

8. Procédé selon l'une des revendications précédentes dans lequel l'étape (1 E2) d'activation préliminaire lorsque cette étape (1E2) est mise en oeuvre, l'étape (1 E3) ou les étapes (1 E3,1 E3') de dépôt, les étapes (1 E5, 1E5') d'activation et l'étape (1 E6) de mise en contact sont réalisées dans une machine de collage par activation de surface comprenant une chambre de dépôt permettant le dépôt de la ou des couches de l'espèce d'intérêt.
